# EUROPEAN PATENT SPECIFICATION

(11) **EP 2 592 290 B1**
(45) Date of publication and mention of the grant of the patent: **14.01.2015**
(21) Application number: 12007631.0
(22) Date of filing: 09.11.2012
(51) Int. Cl.: F16C 33/20, B32B 15/00, B32B 27/00, C23C 28/00

(54) **Multi-layer sliding bearing**
Mehrschichtgleitlager
Palier lisse multi-couches

(30) Priority: 09.11.2011 GB 201119305
(43) Date of publication of application: 15.05.2013
(73) Proprietor: MAHLE International GmbH, 70376 Stuttgart (DE); Mahle Engine Systems UK Limited, Rugby, Warwickshire CV23 0WE (GB); Mahle Composants Moteur France SAS, 74650 Chavanod (FR)
(72) Inventor: Fortune, Cedric, 74100 Annemasse (FR); Laing, Ian Mathew, Rugby, Warwickshire CV21 2QG (GB); Forder, Jon, Rugby, Warwickshire CV21 2QT (GB)
(74) Representative: Pohle, Reinhard

(56) References cited:
- EP-A2- 0 395 130
- DE-A1-102008 060 765
- GB-A- 2 271 779
- GB-A- 2 465 852
- US-A1- 2006 245 675
- US-A1- 2008 159 671
- US-A1- 2008 187 260

## Description

The present invention relates to sliding bearings having a copper-based lining layer and polymer-based bearing material layer, and particularly, though not exclusively, to sliding bearings having a strong backing, such as steel.

### BACKGROUND

Sliding bearings for use as crankshaft journal bearings in internal combustion engines, for example, are usually generally semi-cylindrical in form and generally have a layered construction. Thrust washers for use with such sliding bearings are usually generally semi-annular in form.

A known sliding bearing described in GB2465852 (of common ownership herewith) has a strong steel backing material, a thick lining layer of copper-based alloy provided on the inner face of the backing material, and a polymer-based bearing material is provided on the lining layer. The steel backing material has a thickness in the region of about 1 mm or more. The copper-based alloy is 8 %wt Sn, 1 %wt Ni, and the balance is Cu, apart from incidental impurities and the lining layer is 300 µm thick. The 300µm thick lining layer is provided onto the backing layer by a roll-bonding (thermo-mechanical working process), sintering or casting process. The polymer-based bearing material layer has a thickness of 12 µm, and comprises 12.5 %vol Al, 5.7 %vol PTFE particulate, 4.8 %vol silane, <0.1 %vol other components, and balance (approximately 77 %vol) polyimide/amide. An alternative example is also described in which the lining layer is a 300 µm thickness of an aluminium-based alloy.

However, adhesion of the polymer-based bearing material to the copper-based or aluminium-based lining layer is weak. Accordingly, prior to deposition of the polymer-based bearing material, the copper-based or aluminium-based lining layer is roughened using a grit blasting process, typically using Al₂O₃ grit. The roughening increases adhesion of the polymer-based bearing material due both to enabling mechanical anchoring onto the bearing material, and by increasing the surface area of the interface between the layers.

Disadvantageously, the high levels of roughness required to provide highly enhanced adhesion between the copper-based or aluminium-based lining layer and the polymer-based bearing material necessitates the use of a thick polymer-based coating to fully cover the surface asperities of the roughened lining layer. Further, the grit blasting process creates uneven roughness, necessitating the provision of a substantial thickness of the polymer-based coating beyond the uppermost level of the roughened lining layer to provide a good surface topography of the polymer-based coating. Even after a careful cleaning stage, such a grit blasting process can leave a low concentration of particulate deposits adhering to the surface of the lining layer, which can impair the quality of the polymer-based coating.

US2008/0187260A1 discloses a sliding bearing composite material including a carrier layer of steel and a copper-based bearing metal layer applied thereupon. The copper-based alloy is a bronze having a tin content of 20 to 30% by weight. An aluminum-based running layer is deposited thereon by a sputter process. Finally, a polymer-based slip varnish layer is applied thereon as a run-in layer.

### SUMMARY OF THE DISCLOSURE

According to a first aspect of the invention, there is provided a sliding bearing comprising a Cu-based first layer, an Al-based second layer, and a polymer-based bearing material third layer, wherein the second layer contacts and is directly located between the first and third layers, the first layer is other than a sputter coated layer, and the second layer is a sputter coated layer.

According to a second aspect of the invention, there is provided an engine comprising a sliding bearing, the sliding bearing comprising a Cu-based first layer, an Al-based second layer, and a polymer-based bearing material third layer, wherein the second layer contacts and is directly located between the first and third layers, the first layer is other than a sputter coated layer, and the second layer is a sputter coated layer.

According to a third aspect of the invention, there is provided a flat sheet element for forming a sliding bearing according to the first aspect of the invention.

According to a fourth aspect of the invention, there is provided a method of manufacturing a sliding bearing comprising a Cu-based first layer, an Al-based second layer, and a polymer-based bearing material third layer, wherein the second layer contacts and is directly located between the first and third layers, and the first layer is other than a sputter coated layer, the method comprising sputter coating the second layer onto the first layer.

The second layer may have a thickness of 1 to 10 µm, preferably 1 to 4 µm, and more preferably 2 to 3 µm.

The second layer comprises one or more additive elements selected from the group consisting of Cu, Cr, Ni, Fe, Mg, Mn, Si, Sn, V and Zn, and the balance to 100 %wt of Al, apart from incidental impurities.

The additive elements may comprise less than 15 %wt of the second layer in total.

According to the present invention, the second layer comprises 5.5 to 7 %wt Sn, 0.7 to 1.3% Cu, 0.7 to 1.3 %wt Ni, 1.5 to 3 %wt Si, up to 1 %wt other elements, with the balance to 100 %wt being Al apart from incidental impurities.

The third layer may comprises a matrix of a polyimide/amide plastics polymer material and having distributed throughout the matrix: from 5 to less than 15 %vol of a metal powder; from 1 to 15 %vol of a fluoropolymer, the balance being the polyimide/amide resin apart from incidental impurities.

The polymer-based bearing material layer may comprise 12.5 %vol Al powder, 5.7 %vol PTFE particulate, 4.8 %vol silane powder, < 0.1 %vol other components, and balance (approximately 77 %vol) polyimide/amide.

The polymer-based bearing material layer may have a thickness of 6 to 12 µm.

The first layer may be provided with a backing layer.

The first layer may be sintered onto the backing layer.

The first layer may be roll-bonded onto the backing layer.

The first layer may be formed onto the backing layer by a casting process.

The first layer may have a thickness of 200 to 400 µm.

The sliding bearing may be a half bearing shell or a thrust washer.

The method may further comprise the steps of: making a mixture of a polyimide/amide plastics resin material in a solvent with the metal powder and the fluoropolymer; coating the mixture onto a substrate; treating so as to remove the solvent; and, treating so as to consolidate the polyimide/amide matrix.

### BRIEF DESCRIPTION OF THE DRAWINGS

Embodiments of the invention are further described hereinafter with reference to the accompanying drawing, in which:

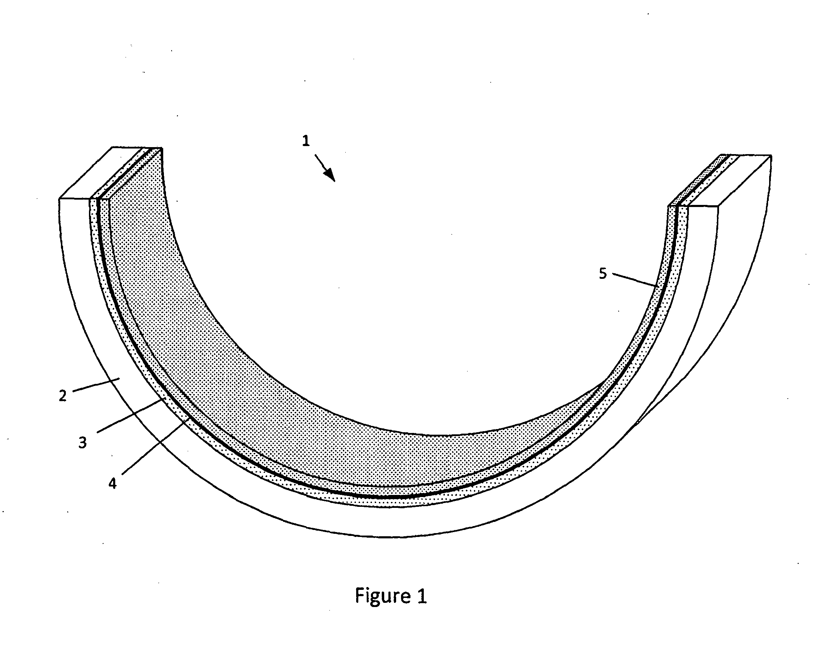

- Figure 1 shows a schematic view of a half bearing according to the present invention.

### DETAILED DESCRIPTION

Like reference numerals refer to like elements throughout.

Figure 1 schematically illustrates a half bearing 1, which is a hollow semi-cylindrical bearing lining shell. The half bearing 1 comprises a strong steel backing 2, a copper-based lining layer 3 within the backing, an aluminium-based interlayer 4 provided directly onto the lining layer, and a polymer-based bearing material layer 5 provided directly onto the interlayer.

The lining layer 3 comprises a lead free Cu-based alloy (a Cu-based alloy having no more than 20 %wt additive elements, with the balance to 100 %wt of Cu, e.g. 8 %wt Sn, 1 %wt Ni, and Cu remaining balance), and has a thickness in the region of 300 µm (e.g. 200 to 400 µm).

The lining layer 3 is provided onto the backing 2 by a known method (that is not by a sputter deposition coating process), such (i) sintering a powder onto the backing in a high temperature furnace (typically accompanied by a mechanical rolling step); (ii) by a roll-bonding process (typically followed by a heat treatment step) during a thermo-mechanical working process; or (iii) by a casting process in which molten metal is spread onto the backing and quenched. The sintering and casting processes are typically used with Cu-based lining layers and the roll-bonding process is typically used with Al-based lining layers. Typically, the blanks for individual bearings are cropped from a coil comprising the backing layer with the Cu- or Al-based lining layer formed thereon. The blanks are then shaped to form half-cylinders or other appropriate shapes, and then typically de-greased before deposition of the interlayer 4 and polymer-based coating 5. However, it will be appreciated that the manufacturing steps may be undertaken in other appropriate orders.

In an example not part of the invention, the interlayer 4 comprises 1.5 %wt Mn with the remaining balance to 100 %wt of Al, apart from incidental impurities. The interlayer 4 is deposited by a sputter coating process, has a thickness of 2 to 3 µm, and is strongly adhered to the lining layer 3.

Advantageously, the sputter coating deposition process can provide a particularly fine grain structure in the interlayer, which can enhance adhesion of the polymer-based bearing material layer. The grain structure is typically columnar, with the crystals grown perpendicular to the growth surface. Advantageously, the sputter process can produce an inhomogeneous elemental distribution of a deposited alloy, providing enhanced bonding at the free surface. For example, with a sputter coated AlMn alloy, under certain conditions higher concentrations of Mn may migrate towards the free surface.

Advantageously the sputtered AlMn alloy provides good heat transfer properties. Also, it provides good mechanical properties, as it is relatively soft, and so can provide good conformability of the half bearing. Further, it allows the final cure of the deposited polymer-based bearing material layer to be at close to 200 °C without risk of degradation of the interlayer.

The polymer-based bearing material layer 5 has a thickness of 9 µm, and comprises 12.5 %vol Al powder, 5.7 %vol PTFE particulate, 4.8 %vol silane powder, < 0.1 %vol other components, and the balance (approximately 77 %vol) of polyimide/amide.

The polymer-based bearing material is applied as a mixture with a solvent. A suitable solvent may comprise n-methyl-2-pyrrolidone xylene and can be employed in various proportions in order to achieve a particular desired viscosity of mixture for coating onto the substrate.

The polymer-based bearing material layer 5 is built up by a spray coating process in which repeated deposition of thin spray coatings is interspersed with flash off phases to remove solvent. Alternatively, the polymer-based bearing material layer 5 could be deposited by a printing process. After the final coating deposition step, the sliding bearing is given a final cure at 190 to 200 °C for about 30 minutes. Note that the above composition of the polymer-based bearing material layer 5 is that which remains in the final material after the solvent has been removed.

Desirably the solvent mixture is of a suitable viscosity that the coating technique of applying the solvent mixture to the substrate results in the final thickness of the plastics polymer bearing material being at a desired thickness without the need to machine to a desired final wall, thickness. However, machining of the plastic polymer material may be undertaken if required.

Aluminium powder having particles in the form of flake platelets of about 1 to 5 µm in size, preferably 2 to 3 µm in size, provides the most suitable form of metal powder addition, although other metal powders may alternatively be used. The flake nature of the powder generally results in the maximum area of metal powder being exposed to a co-operating shaft journal by virtue of the plane of the flakes being orientated generally parallel to the bearing surface. This orientation results from the production method of depositing the bearing material.

A further advantage of the platelet flake morphology of the aluminium powder is that the particles are more securely bonded to the matrix by virtue of the relatively large surface area of each individual particle and thus prevents aluminium particles from being plucked from the matrix during operation.

Polytetrafluoroethylene (PTFE) is preferred, as this is the most effective of the fluoropolymers in terms of reducing the friction coefficient of the bearing material and improved self-lubricating properties. However, other fluoropolymers, such as fluorinated ethylene-propylene (FEP), for example, well known in the bearings art, may be used if desired.

Silane materials have been found to promote stability of the polyimide/amide matrix and have also been found to promote adhesion of the polyimide/amide resin material to the substrate. A suitable silane material may be gamma-aminopropyltriethoxysilane and an addition in the range of 3 to 6 %vol may be made to the mixture. A suitable alternative silane material may comprise bis-(gamma-trimethoxysilpropyl)amine.

Advantageously, as well as bonding strongly to the lining layer 3, the interlayer 4 provides strong chemical bonds at the interface with the polymer-based bearing material layer 5, which provides strong inter-bonding of the two layers without the need for mechanical roughening (e.g. grit blasting) of the surface of the lining layer onto which the polymer-based bearing material layer is deposited in known devices. Further, the use of the sputtered coating can provide a sliding bearing with enhanced fatigue resistance.

According to the invention, the interlayer comprises 6 %wt Sn, 1 % Cu, 1 %wt Ni, and 2 %wt Si, with the balance to 100 %wt being Al apart from incidental impurities.

The substrate 2 and 3 onto which the interlayer 4 and polymer-based bearing material layer 5 are deposited may be in any desired form such as a semi-cylindrical shell for a half bearing, a thrust washer, or as a flat sheet element (e.g. strip) from which a sliding bearing may then be formed after the polymer coating step, for example.

The figure provided herein is schematic and not to scale.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

## Claims

1. A sliding bearing (1) comprising a Cu-based first layer (3), an Al-based second layer (4), and a polymer-based bearing material third layer (5), wherein the second layer (4) contacts and is directly located between the first (3) and third layers (5), the first layer (3) is other than a sputter coated layer, and the second layer (4) is a sputter coated layer,
**characterized in that**
the second layer (4) comprises 5.5 to 7 %wt Sn, 0.7 to 1.3%wt Cu, 0.7 to 1.3 %wt Ni, 1.5 to 3 %wt Si, up to 1 %wt other elements, with the balance to 100 %wt being Al apart from incidental impurities.

2. A sliding bearing (1) according to claim 1, wherein the second layer (4) has a thickness of 1 to 10 µm, preferably 1 to 4 µm, and more preferably 2 to 3 µm.

3. A sliding bearing (1) according to claims 1 or 2, wherein the second layer (4) comprises one or more additive elements selected from the group consisting of Cr, Fe, Mg, Mn, V and Zn,

4. A sliding bearing (1) according to any preceding claim, wherein the third layer (5) comprises a matrix of a polyimide/amide plastics polymer material and having distributed throughout the matrix: from 5 to less than 15 %vol of a metal powder; from 1 to 15 %vol of a fluoropolymer, the balance being the polyimide/amide resin apart from incidental impurities.

5. A sliding bearing (1) according to any one of claims 1 to 3, wherein the third layer (5) comprises 12.5 %vol Al powder, 5.7 %vol PTFE particulate, 4.8 %vol silane powder, < 0.1 %vol other components, and balance (approximately 77 %vol) polyimide/amide.

6. A sliding bearing (1) according to any preceding claim, wherein the third layer (5) has a thickness of 6 to 12 µm

7. A sliding bearing (1) according to any preceding claim, wherein the first layer (3) is provided with a backing layer.

8. A sliding bearing (1) according to claim 7, wherein the first layer (3) is sintered onto the backing layer.

9. A sliding bearing (1) according to claim 7, wherein the first layer (3) is roll-bonded onto the backing layer.

10. A sliding bearing (1) according to claim 7, wherein the first layer (3) is formed onto the backing layer by a casting process.

11. A sliding bearing (1) according to any preceding claim, wherein the first layer (3) has a thickness of 200 to 400 µm.

12. A sliding bearing (1) according to any preceding claim, wherein the sliding bearing is a half bearing shell or a thrust washer.

13. An engine comprising a sliding bearing (1) according to any preceding claim.

14. A flat sheet element for forming a sliding bearing (1) according to one of claims to 11.

15. A method of manufacturing a sliding bearing (1) comprising a Cu-based first layer (3), an Al-based second layer (4), and a polymer-based bearing material third layer (5), wherein the second layer (4) contacts and is directly located between the first (3) and third layers (5), and the first layer (3) is other than a sputter coated layer, the method comprising sputter coating the second layer (4) onto the first layer (3),
**characterized in that**
the second layer (4) comprises 5.5 to 7 %wt Sn, 0.7 to 1.3%wt Cu, 0.7 to 1.3 %wt Ni, 1.5 to 3 %wt Si, up to 1 %wt other elements, with the balance to 100 %wt being Al apart from incidental impurities.

16. A method according to claim 15 wherein the third layer (5) comprises a matrix of a polyimide/amide plastics polymer material and having distributed throughout the matrix: from 5 to less than 15 %vol of a metal powder; from 1 to 15 %vol of a fluoropolymer, the balance being the polyimide/amide resin apart from incidental impurities, the method further comprising the steps of: making a mixture of a polyimide/amide plastics resin material in a solvent with the metal powder and the fluoropolymer; coating the mixture onto a substrate; treating so as to remove the solvent; and, treating so as to consolidate the polyimide/amide matrix.

## Patentansprüche

1. Gleitlager (1), eine auf Cu basierende erste Schicht (3), eine auf Al basierende zweite Schicht (4) und eine dritte Schicht (5) aus einem Lagermaterial auf Polymerbasis umfassend, wobei die zweite Schicht (4) die ersten (3) und dritten Schichten (5) berührt und direkt zwischen ihnen angeordnet ist, wobei die erste Schicht (3) keine durch Sputtern aufgebrachte Schicht ist und die zweite Schicht (4) eine durch Sputtern aufgebracht Schicht ist,
**dadurch gekennzeichnet, dass**
die zweite Schicht (4) 5,5 bis 7 Gew.-% Sn, 0,7 bis 1,3 Gew.-% Cu, 0,7 bis 1,3 Gew.-% Ni, 1,5 bis 3 Gew.-% Si, bis zu 1 Gew.-% andere Elemente umfasst, wobei das, was noch zu 100 % fehlt, abgesehen von nicht gewollten Fremdstoffen, aus Al besteht.

2. Gleitlager (1) nach Anspruch 1, wobei die zweite Schicht (4) eine Dicke von 1 bis 10 µm, vorzugsweise 1 bis 4 µm und stärker bevorzugt von 2 bis 3 µm aufweist.

3. Gleitlager (1) nach Anspruch 1 oder 2, wobei die zweite Schicht (4) eines oder mehrere Zuschlagelemente umfasst, die ausgewählt sind aus der Gruppe bestehend aus Cr, Fe, Mg, Mn, V und Zn.

4. Gleitlager (1) nach einem der vorangehenden Ansprüche, wobei die dritte Schicht (5) eine Matrix aus Polyimid/Amid-Kunststoffpolymermaterial umfasst und verteilt durch die gesamte Matrix aufweist: 5 bis nicht ganz 15 Vol.-% Metallpulver; 1 bis 15 Vol.-% Fluorpolymer und zu übrigen Teilen, abgesehen von nicht-gewollten Fremdstoffen, das Polyimid-/Amidharz.

5. Gleitlager (1) nach einem der Ansprüche 1 bis 3, wobei die dritte Schicht (5) 12,5 Vol.-% Al-Pulver, 5,7 Vol.-% PTFE-Teilchen, 4,8 Vol.-% Silanpulver, < 0,1 Vol.-% andere Bestandteile und zu übrigen Teilen (etwa 77 Vol.-%) Polyimid/Amid umfasst.

6. Gleitlager (1) nach einem der vorangehenden Ansprüche, wobei die dritte Schicht (5) eine Dicke von 6 bis 12 µm aufweist.

7. Gleitlager (1) nach einem der vorangehenden Ansprüche, wobei die erste Schicht (3) mit einer Trägerschicht versehen ist.

8. Gleitlager (1) nach Anspruch 7, wobei die erste Schicht (3) auf die Trägerschicht aufgesintert ist.

9. Gleitlager (1) nach Anspruch 7, wobei die erste Schicht (3) auf die Trägerschicht wahplattiert ist.

10. Gleitlager (1) nach Anspruch 7, wobei die erste Schicht (3) anhand eines Gießverfahrens auf der Verstärkungsschicht ausgebildet ist.

11. Gleitlager (1) nach einem der vorangehenden Ansprüche, wobei die erste Schicht (3) eine Dicke von 200 bis 400 µm aufweist.

12. Gleitlager (1) nach einem der vorangehenden Ansprüche, wobei das Gleitlager eine Halblagerschale oder ein Anlaufscheibe ist.

13. Motor, ein Gleitlager (1) nach einem der vorangehenden Ansprüche umfassend.

14. Ein Flächengebilde darstellendes Element zum Ausbilden eines Gleitlagers (1) nach einem der Ansprüche 1 bis 11.

15. Verfahren zur Herstellung eines Gleitlagers, eine auf Cu basierende erste Schicht (3), eine auf Al basierende zweite Schicht (4) und eine dritte Schicht (5) aus einem Lagermaterial auf Polymerbasis umfassend, wobei die zweite Schicht (4) die ersten (3) und dritten Schichten (5) berührt und direkt zwischen ihnen angeordnet ist und die erste Schicht (3) keine durch Sputtern aufgebrachte Schicht ist, wobei das Verfahren das Aufbringen der zweiten Schicht (4) auf die erste Schicht durch Sputtern umfasst,
**dadurch gekennzeichnet, dass**
die zweite Schicht (4) 5,5 bis 7 Gew.-% Sn, 0,7 bis 1,3 Gew.-% Cu, 0,7 bis 1,3 Gew.-% Ni, 1,5 bis 3 Gew.-% Si, bis zu 1 Gew.-% andere Elemente umfasst, wobei das, was noch zu 100 % fehlt, abgesehen von nicht gewollten Fremdstoffen, aus Al besteht.

16. Verfahren nach Anspruch 15, wobei die dritte Schicht (5) eine Matrix aus Po-lyimid/Amid-Kunststoff-Polymermaterial umfasst und verteilt durch die gesamte Matrix aufweist: 5 bis nicht ganz 15 Vol.-% Metallpulver; 1 bis 15 Vol.-% Fluorpolymer und zu übrigen Teilen, abgesehen von nicht-gewollten Fremdstoffen, das Polyimid-/Amidharz, wobei das Verfahren ferner die folgenden Schritte umfasst: Herstellen einer Mischung aus einem Polyimid/Amid-Kunststoffharzmaterial in einem Lösungsmittel mit dem Metallpulver und dem Fluorpolymer; Aufbringen der Mischung auf ein Substrat; Behandeln, um das Lösungsmittel zu entfernen, und Behandeln, um die Polyimid/Amid-Matrix zu verfestigen.

## Revendications

1. Palier coulissant (1) comprenant une première couche à base de Cu (3), une deuxième couche à base d'Al (4), et une troisième couche de matériaux de palier à base de polymère (5), où la deuxième couche (4) est en contact et est directement située entre la première (3) et la troisième couche (5), la première couche (3) est différente d'une couche obtenue par pulvérisation cathodique, et la deuxième couche (4) est une couche obtenue par pulvérisation cathodique,
**caractérisé en ce que**
la deuxième couche (4) comprend 5,5 à 7 % en masse de Sn, 0,7 à 1,3 % en masse de Cu, 0,7 à 1,3 % en masse de Ni, 1,5 à 3 % en masse de Si, jusqu'à 1 % en masse d'autres éléments, le reste de la composition jusqu'à 100 % en masse étant constitué d'Al à l'exception des impuretés accidentelles.

2. Palier coulissant (1) selon la revendication 1, où la deuxième couche (4) présente une épaisseur comprise entre 1 et 10 µm, préférentiellement entre 1 et 4 µm, et plus préférentiellement entre 2 et 3 µm.

3. Palier coulissant (1) selon les revendications 1 ou 2, où la deuxième couche (4) comprend un ou plusieurs éléments d'addition choisis dans le groupe constitué par Cr, Fe, Mg, Mn, V et Zn.

4. Palier coulissant (1) selon l'une quelconque des revendications précédentes, où la troisième couche (5) comprend une matrice d'un matériau polymère plastique polyimide/amide, et, distribués au travers de la matrice : entre 5 et moins de 15 % en volume d'une poudre métallique ; entre 1 et 15 % en volume d'un fluoropolymère, le reste étant constitué de la résine polyimide/amide à l'exception des impuretés accidentelles.

5. Palier coulissant (1) selon l'une quelconque des revendications 1 à 3, où la troisième couche (5) comprend 12,5 % en volume de poudre d'Al, 5,7 % en volume de particules de PTFE, 4,8 % en volume de poudre de silane, < 0,1 % en volume d'autres composants, et le reste (environ 77 % en volume) de polylmide/amide.

6. Palier coulissant (1) selon l'une quelconque des revendications précédentes, où la troisième couche (5) présente une épaisseur comprise entre 6 et 12 µm.

7. Palier coulissant (1) selon l'une quelconque des revendications précédentes, où la première couche (3) comporte une couche de support.

8. Palier coulissant (1) selon la revendication 7, où la première couche (3) est frittée sur la couche de support.

9. Palier coulissant (1) selon la revendication 7, où la première couche (3) est plaquée par laminage sur la couche de support.

10. Palier coulissant (1) selon la revendication 7, où la première couche (3) est formée sur la couche de support par un processus de coulage.

11. Palier coulissant (1) selon l'une quelconque des revendications précédentes, où la première couche (3) présente une épaisseur comprise entre 200 et 400 µm.

12. Palier coulissant (1) selon l'une quelconque des revendications précédentes, où le palier coulissant est un demi-coussinet de palier ou une rondelle de butée.

13. Moteur comprenant un palier coulissant (1) selon l'une quelconque des revendications précédentes.

14. Élément de type feuille plate pour la formation d'un palier coulissant (1) selon l'une quelconque des revendications 1 à 11.

15. Procédé de fabrication d'un palier coulissant (1) comprenant une première couche à base de Cu (3), une deuxième couche à base d'Al (4), et une troisième couche de matériaux de palier à base de polymère (5), où la deuxième couche (4) est en contact et est directement située entre la première (3) et la troisième couche (5), et la première couche (3) est différente d'une couche obtenue par pulvérisation cathodique, le procédé comprenant la pulvérisation cathodique de la deuxième couche (4) sur la première couche (3),
**caractérisé en ce que**
la deuxième couche (4) comprend 5,5 à 7 % en masse de Sn, 0,7 à 1,3 % en masse de Cu, 0,7 à 1,3 % en masse de Ni, 1,5 à % en masse de Si, jusqu'à 1 % en masse d'autres éléments, le reste de la composition jusqu'à 100 % en masse étant constitué d'Al à l'exception des impuretés accidentelles.

16. Procédé selon la revendication 15, où la troisième couche (5) comprend une matrice d'un matériau polymère plastique polyimide/amide, et, distribués au travers de la matrice : entre 5 et moins de 15 % en volume d'une poudre métallique ; entre 1 et 15 % en volume d'un fluoropolymère, le reste étant constitué de la résine polyimide/amide à l'exception des impuretés accidentelles, le procédé comprenant en outre les étapes suivantes : fabrication d'un mélange d'un matériau de résine plastique polyimide/amide dans un solvant avec la poudre métallique et le fluoropolymère ; revêtement d'un substrat par le mélange ; traitement de sorte à éliminer le solvant; et traitement de sorte à consolider la matrice polyimide/amide.
